# FASCICULE DE BREVET EUROPEEN

(11) **EP 0 801 155 B1**
(45) Date de publication et mention de la délivrance du brevet: **03.07.2002**
(21) Numéro de dépôt: 97400804.7
(22) Date de dépôt: 08.04.1997
(51) Int. Cl.: C30B 23/00, C30B 29/36

(54) **Dispositif et procédé pour la formation de carbure de silicium (SIC) monocristallin sur un germe**
Verfahren und Vorrichtung zur Herstellung einkristallines Siliziumkarbids (SiC) auf einem Keimkristall
Process and apparatus for forming single crystal silicon carbide (SiC) on a seed

(30) Priorité: 10.04.1996 FR 9604450
(43) Date de publication de la demande: 15.10.1997
(73) Titulaire: COMMISSARIAT A L'ENERGIE ATOMIQUE, 75015 Paris Cédex 15 (FR)
(72) Inventeur: Jaussaud, Claude, 38240 Meylan (FR); Madard, Roland, 38320 Eybens (FR); Anikin, Mikhail, 38130 Echirolles (FR); Garcon, Isabelle, 31100 Toulouse (FR)
(74) Mandataire: Signore, Robert

(56) Documents cités:
- WO-A-89/04055
- WO-A-94/23096
- WO-A-96/17113
- PATENT ABSTRACTS OF JAPAN vol. 18, no. 140 (C-1177), 8 Mars 1994 & JP 05 319998 A (SANYO ELECTRIC CO LTD), 3 Décembre 1993,
- PATENT ABSTRACTS OF JAPAN vol. 17, no. 367 (C-1082), 12 Juillet 1993 & JP 05 058774 A (SANYO ELECTRIC CO LTD), 9 Mars 1993,

## Description

### Domaine technique

La présente invention concerne un dispositif et un procédé pour la formation de carbure de silicium monocristallin sur un germe. Le carbure de silicium est encore désigné symboliquement par SiC dans la suite du texte.

L'invention s'applique en particulier à la réalisation de lingots de carbure de silicium monocristallin d'un polytype donné.

Ces lingots sont utilisés pour la fabrication de substrats utilisables en microélectronique.

### Etat de la technique antérieure

Le document (1) dont la référence est indiquée à la fin de la présente description illustre l'utilisation de plaquettes de carbure de silicium dans les domaines de la microélectronique. Pour une telle utilisation, le carbure dé silicium doit présenter une bonne qualité cristalline.

Un procédé connu, pour la production de carbure de silicium de qualité électronique, est basé sur la sublimation d'une poudre de SiC, qui vient se condenser sur un germe de SiC monocristallin.

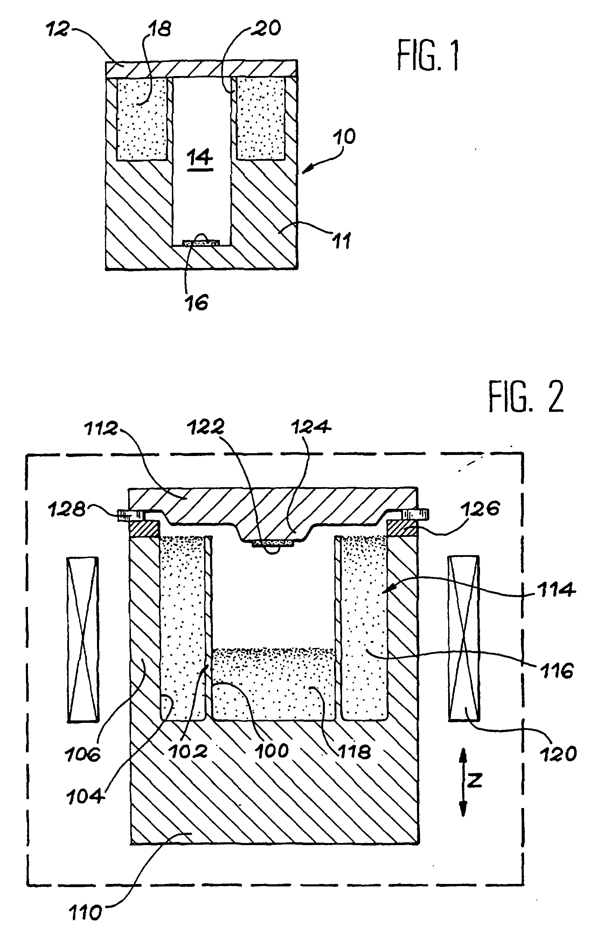

La figure 1 montre à titre indicatif un dispositif utilisé pour la mise en oeuvre de ce procédé de sublimation.

Le dispositif comporte un creuset en graphite 10 avec une paroi latérale 11, de forme générale cylindrique, et recouverte par un couvercle 12. Le creuset 10 et le couvercle 12 définissent une enceinte de sublimation 14 au fond de laquelle est disposé un germe 16 à partir duquel on souhaite former un lingot de carbure de silicium.

La paroi cylindrique 11 du creuset inclut dans sa partie supérieure une chambre 18 formant un réservoir de poudre de SiC. Une fine cloison 20, de graphite, sépare la chambre 18 de l'enceinte de sublimation 14.

Le creuset 10 est disposé dans un four, non représenté sur la figure 1, qui permet de chauffer notamment la poudre de carbure de silicium dans la chambre 18, et le germe 16.

La poudre de SiC et le germe sont respectivement chauffés à des températures T₁ et T₂ telles que T₁ soit supérieure à T₂.

Le carbure de silicium de la chambre 18, se sublime sous l'effet de la chaleur, traverse notamment la cloison 20 et vient se déposer dans l'enceinte 14, en particulier sur le germe 16.

Un dispositif conforme à la figure 1 est décrit dans le document (2) dont la référence est également donnée à la fin de la description. Selon ce document, le choix du graphite pour la réalisation du creuset est souhaitable dans la mesure où il permet de constituer une source de carbone pendant la croissance du lingot sur le germe.

Il apparaît en effet que la sublimation du carbure de silicium n'est pas congruente. La vapeur provenant de la poudre de carbure de silicium dans la chambre 18 ne se compose pas uniquement de SiC, mais d'un mélange de SiC, SiC₂, Si₂C, Si, Si₂, Si₃, C₂ et C₃. De plus, il s'avère que, globalement, une quantité plus importante de silicium que de carbone s'évapore de la poudre.

Par contre, d'autres phénomènes, tels que des phénomènes de migration du silicium dans les parois de graphite, conduisent à un appauvrissement en silicium des vapeurs présentes dans l'enceinte.

Dans le cas du dispositif de la figure 1, le silicium contenu dans les vapeurs produites par sublimation de la poudre de SiC de la chambre 18 a tendance à migrer dans la paroi épaisse 11 du creuset, notamment en-dessous de la chambre 18.

Cette perte de silicium, provoque une graphitisation des lingots de SiC produits. Or, la précipitation de carbone à l'état de graphite dans les lingots conduit à une mauvaise qualité cristalline et à un blocage de la croissance cristalline, ce qui est préjudiciable à la réalisation de substrats destinés à des applications de microélectronique.

Une mesure pour éviter le phénomène de graphitisation consiste à utiliser une poudre de source (dans la chambre 18) contenant à la fois du SiC et du silicium. Cet enrichissement en silicium de la source permet effectivement d'éviter la graphitisation au début de la croissance du lingot de SiC. A ce sujet, on peut se reporter au document (3) dont la référence est indiquée à la fin de la description.

Toutefois, l'ajout de silicium ne permet pas de garder une composition constante de la vapeur pendant toute la croissance du lingot et donc d'éviter complètement la graphitisation. La graphitisation n'est que retardée.

Ainsi, un but de la présente invention est de proposer un dispositif pour la formation de carbure de silicium sur un germe, et en particulier pour la formation d'un lingot de SiC, qui ne présente pas les limitations évoquées ci-dessus.

L'invention vise à obtenir une croissance d'un lingot de SiC de bonne qualité cristalline et à empêcher le phénomène de graphitisation.

Un but de l'invention est également de proposer un procédé de formation d'un lingot de SiC avec ledit dispositif.

### Exposé de l'invention

Pour atteindre ces buts, l'invention a plus précisément pour objet un dispositif pour la formation de SiC sur un germe, comprenant :
- une première enceinte formant creuset, délimitée par au moins une paroi et pouvant recevoir un germe de SiC,
- un réservoir de poudre SiC formant une source principale de SiC,
- des moyens de chauffage de l'enceinte aptes à établir un premier gradient thermique entre la source de SiC et le germe de SiC.

Conformément à l'invention, la (ou les) paroi(s) de la première enceinte est (sont) pour l'essentiel recouverte(s) d'au moins une couche de carbure de silicium. On admet que la paroi est pour l'essentiel recouverte par la couche de SiC, soit lorsque la couche recouvre l'ensemble de la surface de cette paroi soit lorsqu'elle recouvre une majeure partie de la surface de la paroi.

Lors de la formation de SiC sur le germe, au moins une partie de la couche de carbure de silicium recouvrant la paroi se comporte comme une source additionnelle de SiC et permet de compenser la migration dans la paroi du silicium provenant de la source principale.

Cet effet peut être renforcé en établissant également une différence de température entre la couche de carbure de silicium de la paroi, et le germe. Aussi, selon un aspect avantageux de l'invention, il est possible d'équiper le dispositif de moyens de chauffage aptes à établir un deuxième gradient thermique entre la couche de SiC recouvrant la paroi et le germe de SiC. Le premier gradient thermique entre la source principale de SiC et le germe et le deuxième gradient thermique entre la couche de SiC sur la paroi et le germe sont de même signe. La couche de SiC sur la paroi se comporte alors, au moins en partie, comme une source additionnelle.

Tout comme pour la source principale, le carbure de silicium recouvrant pour l'essentiel la paroi peut être sous forme de poudre.

Dans une réalisation particulière du dispositif, l'enceinte peut être délimitée par une paroi latérale cylindrique, un fond et un couvercle. L'ensemble de la paroi latérale cylindrique est recouverte sur sa face extérieure par une couche de poudre de SiC, par exemple. Par ailleurs, comme décrit plus loin, pendant la croissance de SiC sur le germe une couche de SiC se forme aussi sur la face intérieure de la paroi latérale cylindrique. Cette couche constitue alors également une source additionnelle de SiC par rapport au germe.

Avantageusement, une portion inférieure de la paroi latérale et le fond de l'enceinte peuvent former le réservoir de poudre de SiC constituant la source principale. Ainsi, la source principale est directement disposée dans l'enceinte de sublimation.

Le germe de carbure de silicium, disposé également dans l'enceinte de sublimation peut être fixé sur un support du couvercle.

Ce support est préférentiellement conçu de manière à former une éminence du couvercle, tournée vers le fond de l'enceinte, c'est-à-dire vers la source principale de carbure de silicium, par exemple.

Il apparaît en effet que, lors de la croissance d'un lingot de SiC monocristallin sur le germe, du carbure de silicium polycristallin se forme également sur la paroi de l'enceinte et sur le couvercle. En réalisant un support de germe en saillie par rapport au couvercle, on empêche ainsi que le carbure de silicium polycristallin se formant sur le couvercle, autour du germe, et dont la croissance est plus rapide que celle du SiC monocristallin, ne vienne recouvrir le lingot en formation.

Lors de la formation du lingot, le carbure de silicium qui se dépose sur la (les) paroi(s) et sur le couvercle scelle hermétiquement le couvercle sur la paroi. Aussi, pour ne pas abîmer l'enceinte au moment de son ouverture, à la fin de l'opération de croissance du lingot, on peut disposer entre les parois et le couvercle un anneau sacrificiel.

Cet anneau est scié pour ouvrir l'enceinte et est remplacé à chaque nouvelle opération de croissance. Ainsi, l'enceinte formant creuset peut être utilisée plusieurs fois.

L'invention a également pour objet un procédé de formation d'un lingot de carbure de silicium dans un dispositif tel que décrit précédemment.

Le procédé comporte pour l'essentiel les étapes successives suivantes :
a) mise en place d'un germe de SiC dans la première enceinte,
b) mise sous vide de la première enceinte,
c) nettoyage du germe,
d) croissance de SiC monocristallin sur le germe.

Lors de l'étape c) on effectue un nettoyage du germe afin d'améliorer l'état de sa surface. La température Tg du germe est alors momentanément maintenue supérieure à la température Ts de la source principale et à la température Tc de la couche de SiC recouvrant la paroi de l'enceinte. Le germe se comporte alors lui-même comme une source et une sublimation se produit à partir du germe. Cette sublimation a pour effet de polir la surface du germe.

Lors de l'étape d), la température Ts de la source principale est maintenue supérieure à la température Tc de la couche de SiC recouvrant la paroi de l'enceinte. Cette couche, formant une source additionnelle, est elle-même maintenue à une température supérieure à la température Tg du germe.

On observe ainsi que le gradient entre la source et le germe et le gradient entre la couche de SiC et le germe sont toujours de même signe, mais que ce signe change entre l'étape c) (gradient négatif) et l'étape d) (gradient positif).

D'autres caractéristiques et avantages de l'invention ressortiront de la description qui va suivre, en référence aux figures des dessins annexés, donnée à titre purement illustratif et non limitatif.

### Brève description des figures

- La figure 1, déjà décrite, est une coupe schématique d'un dispositif connu pour la formation de SiC sur un germe.
- La figure 2 est une coupe schématique d'une réalisation particulière du dispositif de l'invention lors d'une étape de mise sous vide.
- La figure 3 est une coupe schématique du dispositif de la figure 2 lors d'une étape de formation d'un lingot de carbure de silicium.

### Description détaillée de modes de réalisation de l'invention

Le dispositif de la figure 2, conforme à l'invention comporte une première enceinte 100, formant un creuset, délimitée latéralement par une première paroi cylindrique 102, et une deuxième enceinte 104, concentrique, également délimitée par une deuxième paroi latérale cylindrique 106.

Les enceintes 100 et 104 présentent un fond épais 110 qui a pour l'essentiel une fonction d'inertie thermique, et un couvercle 112 recouvre la partie sommitale des enceintes.

La deuxième paroi cylindrique 106 de la deuxième enceinte entoure la première paroi cylindrique 102 de la première enceinte de façon à ménager un espacement circulaire 114 entre ces parois. L'espacement circulaire 114 est rempli pour l'essentiel de poudre de carbure de silicium. Cette poudre constitue une couche 116 de SiC recouvrant la paroi 102 de la première enceinte, au sens de l'invention.

La partie inférieure de la paroi cylindrique 102 et le fond 110 forment un réservoir 118 également rempli de poudre de SiC. Ce réservoir constitue la source principale de SiC pour former le lingot.

L'ensemble formé par les parois latérales, le fond et le couvercle est réalisé de préférence en graphite. Ce matériau est compatible en effet avec les contraintes imposées par les conditions de sublimation du carbure de silicium. Un creuset en graphite peut supporter des températures élevées (2500°C) et est capable de résister à la pression atmosphérique.

De plus, le graphite reste en équilibre thermodynamique avec le SiC. Cette propriété permet d'éviter toute réaction avec le SiC et donc une altération du dispositif.

Enfin, le graphite n'est pas un dopant du carbure de silicium et peut être obtenu avec une grande pureté.

D'autres matériaux tels que le TiC, HfC, TaC, MoC sont également envisageables pour la réalisation du dispositif. Ils sont cependant plus chers et plus fragiles aux chocs thermiques.

Une ou plusieurs spires conductrices électriques forment des moyens 120 de chauffage électrique par induction pour le creuset.

La ou les spires peuvent être déplacées verticalement le long des parois latérales selon la direction Z indiquée sur la figure afin de chauffer de façon variable différentes parties du dispositif.

Dans un premier temps un germe de SiC 122 est collé, par exemple avec du sucre, sur une éminence 124 du couvercle 112. Puis, après avoir disposé un anneau de graphite 126 au sommet de la paroi 106 de la deuxième enceinte 104, le couvercle, équipé du germe, est disposé au dessus du creuset. Le germe se trouve alors situé en face de la poudre de SiC du réservoir 118.

Une ou plusieurs cales 128 de silicium sont placées entre l'anneau de graphite 126 et le bord du couvercle. Ces cales évitent que le couvercle ne repose de façon étanche sur l'anneau et ne ferme ainsi le creuset.

Un pompage effectué dans une enceinte entourant le dispositif permet ainsi de mettre sous vide le creuset en y réduisant la pression jusqu'à une valeur de l'ordre de 1 à 20 torr (130 à 2600 Pa) par exemple. Cette enceinte est représentée sur la figure par une simple ligne discontinue entourant le dispositif.

Lorsqu'un vide suffisant est atteint, les moyens de chauffage 120 sont alimentés pour augmenter la température du creuset. Puis, quand la température atteint ou dépasse 1410°C les cales 128 de silicium fondent et le couvercle vient s'appuyer sur l'anneau 126 comme le montre la figure 2.

Comme indiqué précédemment, pour nettoyer sa surface, le germe est d'abord chauffé à une température supérieure à celle de la poudre de SiC dans l'espacement 114 et dans le réservoir 118. La spire occupe alors une position haute.

Dans un deuxième temps, la spire est abaissée pour chauffer d'avantage le bas du creuset. Les première et deuxième sources sont alors portées à une température supérieure à celle du germe.

La température de la poudre de SiC dans le réservoir est choisie, par exemple, dans une gamme de températures comprise entre 2200°C et 2350°C tandis que celle du germe est choisie entre 2000°C et 2240°C.

Lorsque les températures des sources de SiC, c'est-à-dire de la poudre dans le réservoir 118 et de la poudre dans l'espacement 114 sont maintenues supérieures à la température du germe, le carbure de silicium se sublime à partir des sources et vient se condenser dans sa forme monocristalline sur le germe. Selon la qualité de germe on peut ainsi former un lingot avec un ou plusieurs polytypes.

Grâce aux caractéristiques de l'invention une migration dans les parois du creuset du silicium provenant de la sublimation de la source principale, c'est-à-dire de la poudre du réservoir 118, est évitée ou compensée.

En effet la couche de poudre de SiC qui recouvre les parois latérales se comporte également comme une source de SiC. Les vapeurs de SiC de cette source traversent la paroi latérale 102 poreuse et limitent la migration du silicium dans ces parois. Peu à peu la paroi latérale poreuse se bouche avec du carbure de silicium puis se comporte elle-même comme une source de SiC.

On peut noter par ailleurs que les vapeurs de SiC provenant des sources, se condensent également sur la surface intérieure des parois de la première enceinte, essentiellement sous la forme de SiC polycristallin.

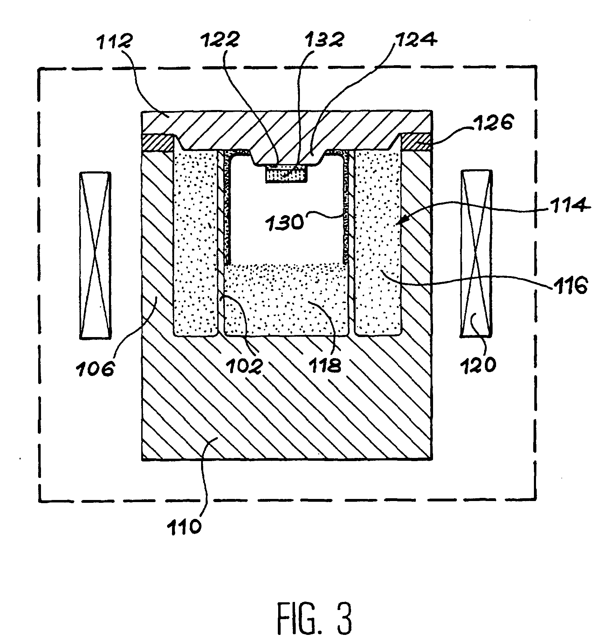

Ainsi, au cours du procédé de formation d'un lingot de SiC l'ensemble de la paroi de l'enceinte se recouvre intérieurement d'une deuxième couche de SiC indiquée avec la référence 130 sur la figure 3.

Les parois latérales sont ainsi recouvertes de la couche intérieure de SiC 130 formée par condensation et de la couche extérieure constituée par la poudre de SiC.

Comme le montre la figure 3, la couche 130 de SiC polycristallin recouvre également le couvercle 112 et le scelle hermétiquement sur les parois latérales.

Le rôle de la couche 130 est double. Cette couche permet d'une part de réaliser autour du germe un environnement uniquement formé de SiC et se comporte également comme une source de SiC par rapport au germe. Ceci contribue à la qualité cristalline du lingot formé. Par ailleurs, la couche 130 permet de rendre les parois du creuset étanches et empêche toute migration du silicium provenant de la sublimation du SiC de la source principale.

Le lingot formé sur le germe est indiqué avec la référence 132. La durée de sa croissance peut aller, par exemple, de 30 minutes à plusieurs heures. Le creuset est ensuite refroidi et l'anneau 126 est découpé pour ouvrir l'enceinte et récupérer le lingot 132 sur le couvercle.

### DOCUMENTS CITES DANS LA DESCRIPTION

***(1)***
   US-A-5 349 207
***(2)***
   US-A-4 866 005
***(3)***
   Study of SiC Single Crystal Sublimation Growth Conditions de I. Garçon et al.
   E-MRS 1994, Spring meeting, Strasbourg, France Symposium E, High Temperature Electronics, pages 1-8.

## Revendications

1. Dispositif pour la formation de SiC sur un germe, comprenant :
- une première enceinte (100), formant creuset, délimitée par au moins une paroi (102, 110, 112) et pouvant recevoir un germe de SiC (122),
- un réservoir (118) de poudre de SiC, formant une source de SiC,
- des moyens (120) de chauffage de l'enceinte aptes à établir un premier gradient thermique entre la source de SiC (118) et le germe de SiC (122),
**caractérisé en ce que** la paroi (102, 110, 112) est pour l'essentiel recouverte d'au moins une couche (116) de SiC.

2. Dispositif selon la revendication 1, **caractérisé en ce que** la couche (116) de SiC est une couche de SiC sous forme de poudre.

3. Dispositif selon la revendication 2, **caractérisé en ce que** l'enceinte (100) est délimitée par une paroi latérale cylindrique (102), un fond (110) et un couvercle (122), et **en ce que** l'ensemble de la paroi cylindrique (102) est recouverte de la couche (116) de poudre de SiC.

4. Dispositif selon la revendication 3, **caractérisé en ce que** une portion inférieure de la paroi latérale (102) et le fond (110) forment le réservoir (118) de poudre de SiC.

5. Dispositif selon la revendication 3, **caractérisé en ce que** le couvercle (112) comporte un support pour le germe de SiC (122).

6. Dispositif selon la revendication 5, **caractérisé en ce que** le support forme une éminence (124) du couvercle (112) tournée vers le fond (110).

7. Dispositif selon la revendication 1, **caractérisé en ce que** les moyens de chauffage (120) sont aptes à établir un deuxième gradient thermique entre la couche de SiC (116) recouvrant la paroi et le germe (122) de SiC, le premier et le deuxième gradients thermiques étant de même signe.

8. Dispositif selon la revendication 3, **caractérisé en ce qu'**il comporte une deuxième enceinte (104) entourant la première enceinte (100), la deuxième enceinte présentant une paroi latérale cylindrique (106) et un espacement (114) étant ménagé entre les parois latérales des première et deuxième enceintes, et **en ce que** l'espacement (114) contient de la poudre de SiC formant la couche (116) de SiC.

9. Dispositif selon la revendication 8, **caractérisé en ce qu'**il comporte un anneau sacrificiel (126) entre la paroi latérale (106) de la deuxième enceinte et le couvercle.

10. Dispositif selon la revendication 1, **caractérisé en ce que** la paroi latérale (102) de la première enceinte, le fond (110) et le couvercle (112) sont réalisés en graphite.

11. Dispositif selon la revendication 1, **caractérisé en ce que** la paroi latérale (102) de la première enceinte, le fond (110) et le couvercle (112) sont réalisés en au moins l'un des matériaux suivants : TiC, HfC, TaC, MoC.

12. Procédé de formation d'un lingot de SiC avec un dispositif conforme à la revendication 1, **caractérisé en ce qu'**il comporte les étapes successives suivantes :
a) misé en place d'un germe de SiC (112) dans la première enceinte (100),
b) mise sous vide de la première enceinte (100),
c) nettoyage du germe (122),
d) croissance du SiC sur le germe (122).

13. Procédé selon la revendication 12, **caractérisé en ce que** lors de l'étape c) des températures Tg, Ts et Tc respectivement du germe (122), de la source (118) et de la couche de SiC (116) sont telles que Tg>Ts et Tg>Tc.

14. Procédé selon la revendication 12, **caractérisé en ce que** lors de l'étape d) des températures Tg, Ts et Tc respectivement du germe (122), de la source (118) et de la couche de SiC (116) sont telles que Ts>Tc>Tg.

15. Procédé selon la revendication 12, **caractérisé en ce qu'**avant l'étape b) de mise sous vide on dispose au moins une cale de silicium (128) entre une paroi latérale (106) de l'enceinte et un couvercle (112) de l'enceinte et après l'étape b) on fait fondre la cale de silicium pour fermer le couvercle sur la paroi latérale.

## Patentansprüche

1. Vorrichtung für die Bildung von SiC auf einem Kristallkeim, umfassend:
- einen ersten, einen Tiegel bildenden Behälter (100), der durch wenigstens eine Wand (102, 110, 112) begrenzt ist und der einen SiC-Kristallkeim (122) aufnehmen kann,
- einen Vorratsbehälter (118) von SiC-Pulver, das eine SiC-Quelle bildet,
- Einrichtungen (120) zur Erwärmung des Behälters, geeignet, einen ersten thermischen Gradienten zwischen der SiC-Quelle (118) und dem SiC-Kristallkeim (122) herzustellen,
**dadurch gekennzeichnet, dass** die Wand (102, 110, 112): im wesentlichen mit wenigstens einer Schicht (116) von SiC bedeckt ist.

2. Vorrichtung nach Anspruch 1, **dadurch gekennzeichnet, dass** die Schicht (116) von SiC eine Schicht von SiC in Form von Pulver ist.

3. Vorrichtung nach Anspruch 2, **dadurch gekennzeichnet, dass** der Behälter (100) durch eine seitliche zylindrische Wand (102), einen Boden (110) und einen Deckel (112) begrenzt ist, und dass die Gesamtheit der zylindrischen Wand (102) mit der Schicht (116) von SiC-Pulver bedeckt ist.

4. Vorrichtung nach Anspruch 3, **dadurch gekennzeichnet, dass** ein unterer Teil der seitlichen Wand (102) und der Boden (110) den Vorratsbehälter (118) von SiC-Pulver bilden.

5. Vorrichtung nach Anspruch 3, **dadurch gekennzeichnet, dass** der Deckel (112) einen Träger für den SiC-Kristallkeim (122) umfasst.

6. Vorrichtung nach Anspruch 5, **dadurch gekennzeichnet, dass** der Träger einen gegen den Boden (110) gerichteten Vorsprung (124) des Deckels (112) bildet.

7. Vorrichtung nach Anspruch 1, **dadurch gekennzeichnet, dass** die Einrichtungen zur Erwärmung (120) geeignet sind, einen zweiten thermischen Gradienten zwischen der Schicht von SiC (116), die die Wand bedeckt, und dem SiC-Kristallkeim (122) herzustellen, wobei der erste und der zweite thermische Gradient von gleichem Vorzeichen sind.

8. Vorrichtung nach Anspruch 3, **dadurch gekennzeichnet, dass** sie einen zweiten Behälter (104) umfasst, der den ersten Behälter (100) umgibt, wobei der zweite Behälter eine zylindrische seitliche Wand (106) und einen Zwischenraum (114) aufweist, der zwischen den seitlichen Wänden des ersten und des zweiten Behälters eingerichtet ist, und dass der Zwischenraum (114) SiC-Pulver enthält, das die Schicht (116) von SiC bildet.

9. Vorrichtung nach Anspruch 8, **dadurch gekennzeichnet, dass** sie einen Opferring (126) zwischen der seitlichen Wand (106) des zweiten Behälters und dem Deckel umfasst.

10. Vorrichtung nach Anspruch 1, **dadurch gekennzeichnet, dass** die seitliche Wand (102) des ersten Behälters, der Boden (110) und der Deckel (112) aus Graphit hergestellt sind.

11. Vorrichtung nach Anspruch 1, **dadurch gekennzeichnet, dass** die seitliche Wand (102) des ersten Behälters, der Boden (110) und der Deckel (112) aus wenigstens einem der folgenden Materialien hergestellt sind: TiC, HfC, TaC, MoC.

12. Verfahren zur Bildung eines SiC-Barrens mit einer Vorrichtung entsprechend Anspruch 1, **dadurch gekennzeichnet, dass** sie nacheinander die folgenden Schritte umfasst:
a) Platzierung eines SiC-Kristallkeims (112) in dem ersten Behälter (100),
b) Evakuierung des ersten Behälters (100),
c) Reinigung des Kristallkeims (122),
d) Wachstum des SiC auf dem Kristallkeim (122).

13. Verfahren nach Anspruch 12, **dadurch gekennzeichnet, dass** während Schritt c) Temperaturen Tg, Ts und Tc des Kristallkeims (122), der Quelle (118) bzw. der Schicht von SiC (116) derart sind, dass Tg>Ts und Tg>Tc.

14. Verfahren nach Anspruch 12, **dadurch gekennzeichnet, dass** während Schritt d) Temperaturen Tg, Ts und Tc des Kristallkeims (122), der Quelle (118) bzw. der Schicht von SiC (116) derart sind, dass Ts>Tc>Tg.

15. Verfahren nach Anspruch 12, **dadurch gekennzeichnet, dass** man vor dem Schritt b) der Evakuierung wenigstens eine Einlage von Silicium (128) zwischen einer seitlichen Wand (106) des Behälters und einem Deckel (112) des Behälters anordnet und dass man nach Schritt b) die Einlage von Silicium schmelzen lässt, um den Deckel auf der seitlichen Wand zu schließen.

## Claims

1. Apparatus for the formation of SiC on a nucleus comprising a first enclosure (100), forming a crucible, defined by at least one wall (102, 110, 112) and able to receive a SiC nucleus (122), a SiC powder reservoir (118) forming a SiC source, means (120) for heating the enclosure able to establish a first temperature gradient between the SiC source (118) and the SiC nucleus (122), **characterized in that** the wall (102, 110, 112) is essentially covered by at least one SiC layer (116).

2. Apparatus according to claim 1, **characterized in that** the SiC layer (116) is a SiC layer in powder form.

3. Apparatus according to claim 2, **characterized in that** the enclosure (100) is defined by a cylindrical side wall (102), a bottom (110) and a cover (122) and **in that** the complete cylindrical wall (102) is covered by the SiC powder layer (116).

4. Apparatus according to claim 3, **characterized in that** a lower portion of the side wall (102) and the bottom (110) form the SiC powder reservoir (118).

5. Apparatus according to claim 3, **characterized in that** the cover (112) has a support for the SiC nucleus (122).

6. Apparatus according to claim 5, **characterized in that** the support forms a protuberance (124) of the cover (112) turned towards the bottom (110).

7. Apparatus according to claim 1, **characterized in that** the heating means (120) are able to establish a second temperature gradient between the SiC layer (116) covering the wall and the SiC nucleus (122), the first and second temperature gradients having the same sign.

8. Apparatus according to claim 3, **characterized in that** it has a second enclosure (104) surrounding the first enclosure (100), the second enclosure having a cylindrical side wall (106) and a clearance (114) is provided between the side walls of the first and second enclosures and the clearance (114) contains the SiC powder forming the SiC layer (116).

9. Apparatus according to claim 8, **characterized in that** it has a sacrificial ring (126) between the side wall (106) of the second enclosure and the cover.

10. Apparatus according to claim 1, **characterized in that** the side wall (102) of the first enclosure, the bottom (110) and the cover (112) are made from graphite.

11. Apparatus according to claim 1, **characterized in that** the side wall (102) of the first enclosure, the bottom (110) and the cover (112) are made from at least one of the following materials: TiC, HfC, Tac, MoC.

12. Process for the formation of a SiC ingot with an apparatus according to claim 1, **characterized in that** it comprises the following successive stages:
a) placing a SiC nucleus (112) in the first enclosure (100),
b) vacuumizing the first enclosure (100),
c) cleaning the nucleus (122).
d) growth of SiC on the nucleus (122).

13. Process according to claim 12, **characterized in that** during stage c), temperatures Tg, Ts and Tc respectively of the nucleus (122), source (118) and SiC layer (116) are such that Tg > Ts and Tg > Tc.

14. Process according to claim 12, **characterized in that** during stage d), temperatures Tg, Ts and Tc respectively of the nucleus (122), source (118), and SiC layer (116) are such that Ts > Tc > Tg.

15. Process according to claim 12, **characterized in that** prior to the vacuumizing stage b), at least one silicon shim (128) is placed between the enclosure side wall (106) and a cover (112) of the enclosure and following stage b) the silicon shim is melted to seal the cover on the side wall.
